# EUROPÄISCHE PATENTSCHRIFT

(11) **EP 0 377 768 B1**
(45) Veröffentlichungstag und Bekanntmachung des Hinweises auf die Patenterteilung: **19.07.1995**
(21) Anmeldenummer: 89100582.9
(22) Anmeldetag: 13.01.1989
(51) Int. Cl.: H03K 19/003

(54) **Leitungsendstufe**
Line end stage
Etage final pour commande de ligne

(43) Veröffentlichungstag der Anmeldung: 18.07.1990
(73) Patentinhaber: SIEMENS AKTIENGESELLSCHAFT, 80333 München (DE)
(72) Erfinder: Meyer, Ralph, Dipl.-Ing., D-8038 Gröbenzell (DE); Müller, Rudi, Dr., D-8038 Gröbenzell (DE)

(56) Entgegenhaltungen:
- US-A- 4 752 703
- US-A- 4 791 326
- PATENT ABSTRACTS OF JAPAN, Band 8, Nr. 95 (E-242)[1532], 2. Mai 1984;& JP-A-59 12 632
- PATENT ABSTRACTS OF JAPAN, Band 11, Nr. 314 (E-549)[2761], 13. Oktober 1987;& JP-A-62 108 616
- P.HOROWITZ & W.HILL: "The Art of Electronics", 1984, Cambridge University Press, Cambridge, US; Seiten 72, 586, 587

## Beschreibung

Die Erfindung betrifft eine Schaltungsanordnung mit komplementären MOS-Ausgangstransistoren nach dem Oberbegriff des Patentanspruches 1.

In vielen Bereichen der Nachrichtentechnik werden zunehmend CMOS-Bausteine auch für hohe Übertragungsgeschwindigkeiten eingesetzt. Zur Übertragung von digitalen Signalen zu anderen Geräten oder entfernt angeordneten Baugruppen werden Leitungstreiber verwendet. Die Leitungen sind in der Regel kapazitiv belastet und es treten am Leitungsende Reflexionen auf, so daß die Form der empfangenen digitalen Impulse im wesentlichen von der Leitungslänge und von der Netzstruktur bestimmt wird. Um definierte Verhältnisse zu erreichen und Störeinflüsse durch Reflexionen zu minimieren, verwendet man in der Regel abgeschlossene Leitungen. Die Ausgangsschaltungen der Leitungstreiber müssen in der Lage sein, über diese Leitungen möglichst unverzerrte Impulse zu schicken. Außerdem ist es häufig wünschenswert, Ausgangspegel zu erzeugen, die ECL-Bausteine als Eingangspegel verarbeiten können. Hierzu muß der hohe Signalpegel der CMOS-Technologie an die Ubertragungsumgebung angepaßt werden, d. h., der Signalhub muß verringert werden. Änderungen der Umgebungsbedingungen, wie Temperatur- und Versorgungsspannungsschwankungen sowie technologieabhängiger Parameterstreuungen ändern den Ausgangswiderstand der Leitungstreiber und führen ohne Gegenmaßnahmen zu Änderungen des Signalpegels.

Es ist bekannt, Open-Drain-Leitungstreiber zu verwenden, bei denen jeweils das Drain des Ausgangstransistors über die Leitung und einen Leitungswiderstand an einer Abschlußspannung angeschaltet ist. Diese Schaltung hat jedoch mehrere Nachteile. Die Ansteuerung erfolgt unsymmetrisch, ein logischer Zustand liegt auf dem Potential der Abschlußspannung, die Amplitude ist unsymmetrisch und es werden geometrisch sehr große Transistoren benötigt.

Aus Datenbüchern der Firma National Semiconductor Corporation, Santen Clara, Californien sind Tri-State-Buffer MM54HC240/74HC240 bekannt, die symmetrische CMOS-Endstufen aufweisen. Diese liefern zwar weitgehend symmetrische Ausgangssignale, indem sie jeweils einen Ausgangstransistor durchschalten, sie haben jedoch sonst die vorstehend genannten Eigenschaften.

Aus der US-A-4 791 326 ist eine mit komplementären MOS-Transistoren arbeitende Ausgangsschaltung zum Schalten mit konstanten Strömen bekannt. Dabei sind die Drain-Anschlüsse der komplementären MOS-Ausgangstransistoren zusammengeschaltet und bilden somit den Ausgang der Schaltung. In Reihe zur Source-Drain-Strecke jedes MOS-Ausgangstransistors ist ein steuerbarer MOS-Transistor angeordnet. Die der bekannten Ausgangsschaltung zugrundeliegende Aufgabe besteht darin, Impulse unabhängig von der Schaltgeschwindigkeit ohne Verzerrungen zu übertragen.

Aufgabe der Erfindung ist es, eine Schaltungsanordnung mit komplementären MOS-Transistoren anzugeben, die als Pegelumsetzer arbeitet.

Diese Aufgabe wird durch die im Patentanspruch 1 angegebenen Merkmale gelöst. Weitere vorteilhafte Ausbildungen sind in den Unteransprüchen angegeben. Zur Pegelumsetzung ist der gemeinsame Ausgang der komplementären MOS-Ausgangstransistoren über eine Leitung an einen Leitungsabschlußwiderstand geführt, der an einem Abschlußpotential liegt. Die Spannungsamplitude kann am Eingang einer nachfolgenden Eingangsschaltung symmetrisch um das Abschlußpotential eingestellt werden. Auf diese Weise ist ein definierter Leitungsabschluß und gleichzeitig ein symmetrischer Spannungshub um ein Abschlußpotential erreicht. Das Abschlußpotential ist eine definierte Schaltschwelle für nachfolgende Eingangsstufen, deren Schaltzeiten für beide logische Pegel nahezu gleich eingestellt werden können. Die Impulsamplitude läßt sich über Steuerspannungen für die Ausgangstransistoren festlegen. Wegen des angewandten Schaltungsprinzips ("push-pull") können die Abmessungen der Ausgangstransistoren wesentlich verkleinert werden.

Durch Sperren der Stromquellen kann ein Tri-State-Ausgang realisiert werden.

Ausführungsbeispiele der Erfindung werden anhand von Figuren näher erläutert.

Es zeigen:
- Figur 1: eine erfindungsgemäße Schaltungsanordnung mit einer Ausgangsschaltung eines Leitungstreibers und
- Figur 2: die Schaltungsanordnung mit einer Stromspiegelschaltungen enthaltenden Ausgangsstufe

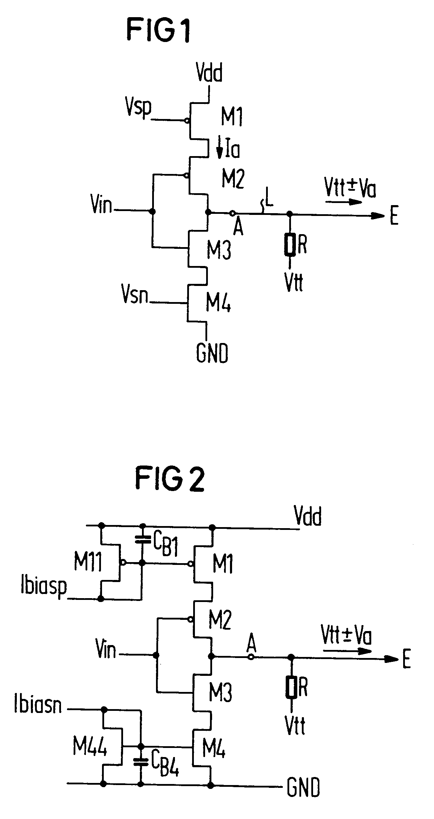

Die in Figur 1 dargestellte Gegentakt-Ausgangsschaltung enthält die Reihenschaltung von zwei PMOS-Transistoren M1, M2 und zwei NMOS-Transistoren M3 und M4. Diese Reihenschaltung liegt an einer Betriebsspannung, deren Potentiale mit Vdd und GND bezeichnet sind. Die MOS-Ausgangstransistoren M2 und M3 werden über eine Steuerspannung Vin angesteuert. Die Drain-Anschlüsse der MOS-Ausgangstransistoren sind zusammengeschaltet und bilden den Ausgang A, der über eine Leitung L und einen Leitungsabschlußwiderstand R an ein Abschlußpotential Vtt liegt. Das Gate des ersten steuerbaren PMOS-Transistors M1 wird von einer ersten Steuerspannung Vsp angesteuert und das Gate des steuerbaren vierten NMOS-Transistors M4 wird von einer zweiten Steuerspannung Vsn angesteuert. Über die Steuerspannungen Vsp und Vsn können die maximal fließenden Leitungsströme Ia auf der Leitung L und damit die Spannungsamplituden ± Va am Eingang E einer Eingangsschaltung eingestellt werden. Es ist darauf zu achten, daß die MOS-Transistoren M1 und M4 bei den eingestellten Strömen ausreichend im Sättigungsbereich sind und daß für die Ausgangstransistoren M2 und M3 eine ausreichende Drain-Source-Spannung zur Verfügung steht, damit sie den gewünschten Strom sicher schalten können und nicht selbstbegrenzend wirken. Die geometrische Dimensionierung der Transistoren erfolgt anhand der technologieabhängigen Transistorkennlinien. Die Steuerspannungen können extern zugeführt werden oder innerhalb des Bausteins erzeugt werden.

Die MOS-Transistoren M1 und M4 können auch als Konstantstromquellen geschaltet werden, wie dies beispielsweise in "Halbleiter-Schaltungstechnik" von Tietze und Schenk, 2. Auflage, Springer Verlag, 1971, Seite 129 angegeben ist, wenn die Leitungsendstufen nur für jeweils einen Anwendungsfall vorgesehen sind.

In Figur 2 werden Stromspiegelschaltungen als Stromquellen verwendet. Der erste PMOS-Transistor M1 bildet mit einem weiteren PMOS-Transistor M11 eine Stromspiegelschaltung. Die Gates sind zusammengeschaltet. Beide Source-Anschlüsse liegen auf dem Versorgungspotential Vdd und der Drain-Anschluß ist beim weiteren PMOS-Transistor M11 mit den zusammengeschalteten Gate-Anschlüssen verbunden. Die Ansteuerung erfolgt jetzt strommäßig mit einem Steuerstrom Ibiasp über den Drain-Anschluß des weiteren Transistors. In entsprechender Weise bilden der vierte NMOS-Transistor M4 mit einem zugehörigen weiteren NMOS-Transistor M44 eine weitere Stromspiegelschaltung, die über einen Steuerstrom Ibiasn angesteuert wird.

Die Stromspiegelschaltungen haben die Eigenschaft, daß die Steuerströme Ibiasp und Ibiasn die Ströme auch jeweils im anderen Transistor bestimmen. Die Steuerströme berechnen sich nach Ibias = Ia/n, wobei n = W/L(Mn) / W/L(Mnn) ist und W die Breite der Drain-Source-Ausdehnung und L deren Länge angibt. Die Steuerströme können hierbei durch einen - gegebenenfalls externen - Präzisionswiderstand, der an einer konstant gehaltenen Spannung liegt, erzeugt werden.

Anstelle der einfache Stromspiegelschaltungen können auch deren Varianten, beispielsweise Wilson- oder Kaskodenstromspiegel Verwendung finden.

Es ist auch möglich, mehrere gesteuerte Transistoren M1 oder M4 von verschiedenen Leitungsendstufen mit ihren Gates zusammenzuschalten und mit jeweils einem einzigen weiteren Transistor M11 oder M44 eine Stromspiegelschaltung zu bilden, wobei allerdings die Toleranzen zu beachten sind.

Der Steuerstrom kann selbstverständlich auch von einer Konstantstromquelle geliefert werden, die durch einen weiteren MOS-Transistor realisiert werden kann.

Durch Abblockkondensatoren C_{B1} und C_{B4} an den Gate-Anschlüssen des ersten und des vierten MOS-Transistors lassen sich Überschwinger reduzieren.

Durch Sperren des PMOS-Transistors M1 und des NMOS-Transistors M4 kann auch eine Tri-State-Ausgangsschaltung realisiert werden.

Prinzipiell können auch entsprechende bipolare Schaltungen aufgebaut werden.

## Patentansprüche

1. Schaltungsanordnung mit komplementären MOS-Ausgangstransistoren (M2, M3), deren zusammengeschaltete Drain-Anschlüsse den Ausgang (A) bilden und deren zusammengeschaltete Gate-Anschlüsse gemeinsam angesteuert werden, mit jeweils einem in Reihe zur Source-Drain-Strecke jedes MOS-Ausgangstransistors (M2, M3) angeordneten, als steuerbare Konstantstromquelle wirkenden MOS-Transistor (M1,M4) und Mitteln (Vsp,Vsn;Ibiasp,Ibiasn) zur Steuerung dieses Transistors (M1,M4),
**dadurch gekennzeichnet,**
daß zur Pegelumsetzung der Ausgang (A) über eine Leitung (L) an einen an ein Abschlußpotential (Vtt) angeschalteten Leitungsabschlußwiderstand (R) geführt ist und die Spannungsamplitude (±Va) am Eingang (E) einer nachfolgenden Eingangsschaltung über die Mittel (Vsp,Vsn;Ibiasp,Ibiasn) symmetrisch um das Abschlußpotential (Vtt) einstellbar ist.

2. Schaltungsanordnung nach Anspruch 1,
**dadurch gekennzeichnet,**
daß jeder in Reihe zur Source-Drain-Strecke des MOS-Ausgangstransistors (M2,M3) angeordnete MOS-Transistor (M1,M4) mit einem weiteren MOS-Transistor (M11,M44) eine Stromspiegelschaltung bildet.

3. Schaltungsanordnung nach Anspruch 1,
**dadurch gekennzeichnet,**
daß jeweils die Gate-Anschlüsse von mehreren steuerbaren MOS-Transistoren (M1 oder M4) von mehreren Leitungsendstufen mit einem einzigen weiteren MOS-Transistor (M11 oder M44) zu einer Stromspiegelschaltung zusammengeschaltet sind.

4. Schaltungsanordnungch Anspruch 2 oder 3,
**dadurch gekennzeichnet,**
daß zur Erzeugung eines Steuerstroms (Ibiasp,Ibiasn) für die Stromspiegelschaltung ein an einer konstanten Spannung liegender Präzisionswiderstand vorgesehen ist.

5. Schaltungsanordnung nach einem der vorhergehenden Ansprüche,
**dadurch gekennzeichnet,**
daß die steuerbaren MOS-Transistoren (M1, M4) gleichzeitig sperrbar sind.

6. Schaltungsanordnung nach einem der vorhergehenden Ansprüche,
**dadurch gekennzeichnet,**
daß an die Gate-Anschlüsse der steuerbaren MOS-Transistoren (M1, M4) Abblockkondensatoren (C_{B1}, C_{B4}) angeschaltet sind.

## Claims

1. Circuit arrangement having complementary MOS output transistors (M2, M3) whose interconnected drain connections form the output (A) and whose interconnected gate connections are driven jointly, having in each case one MOS transistor (M1, M4), which is arranged in series with the source-drain path of each MOS output transistor (M2, M3) and acts as a controllable constant-current source, and means (Vsp, Vsn; Ibiasp, Ibiasn) for controlling this transistor (M1, M4), characterized in that the output (A) is connected via a line (L) to a line terminating resistor (R), which is connected to a terminating potential (Vtt), for level conversion, and the voltage amplitude (±Va) at the input (E) of a downstream input circuit can be set symmetrically about the terminating potential (Vtt) via the means (Vsp, Vsn; Ibiasp, Ibiasn).

2. Circuit arrangement according to Claim 1, characterized in that each MOS transistor (M1, M4) which is arranged in series with the source-drain path of the MOS output transistor (M2, M3) forms a current mirror circuit with a further MOS transistor (M11, M44).

3. Circuit arrangement according to Claim 1, characterized in that the gate connections of a plurality of controllable MOS transistors (M1 or M4) of a plurality of line output stages are in each case interconnected with a single further MOS transistor (M11 or M44) to form a current mirror circuit.

4. Circuit arrangement according to Claim 2 or 3, characterized in that a precision resistor, which is connected to a constant voltage, is provided in order to produce a control current (Ibiasp, Ibiasn) for the current mirror circuit.

5. Circuit arrangement according to one of the preceding claims, characterized in that the controllable MOS transistors (M1, M4) can be switched off simultaneously.

6. Circuit arrangement according to one of the preceding claims, characterized in that blocking capacitors (C_{B1}, C_{B4}) are connected to the gate connections of the controllable MOS transistors (M1, M4).

## Revendications

1. Montage comportant des transistors de sortie MOS complémentaires (M2 et M3), dont les bornes de drain interconnectées forment la sortie (A) et dont les bornes de grille interconnectées sont commandées en commun, et comportant un transistor MOS (M1,M4), respectivement monté en série avec la voie source-drain de chaque transistor de sortie MOS (M2,M3) et agissant en tant que source de courant constant commandable, et des moyens (Vsp,Vsn; Ibiasp, Ibiasn) pour la commande de ce transistor (M1,M4), caractérisé par le fait que pour la conversion du niveau, la sortie (A) est reliée, par l'intermédiaire d'une ligne (L), à une résistance de terminaison de ligne (R), qui est raccordée à un potentiel de terminaison (Vtt), et l'amplitude de tension (±Va) présente à l'entrée (E) d'un circuit d'entrée aval peut être réglée symétriquement autour du potentiel de terminaison (Vtt), par l'intermédiaire des moyens (Vsp,Vsn; Ibiasp,Ibiasn).

2. Montage suivant la revendication 1, caractérisé par le fait que chaque transistor MOS (M1,M4), qui est disposé en série avec la voie source-drain du transistor de sortie (M2,M3), forme, avec un autre transistor MOS (M11, M14), un circuit formant miroir de courant.

3. Montage suivant la revendication 1, caractérisé par le fait que respectivement les bornes de grille de plusieurs transistors MOS commandables (M1 ou M4) de plusieurs étages finals de lignes sont interconnectés à un seul autre transistor MOS (M11 ou M44) pour constituer un circuit formant miroir de courant.

4. Montage suivant la revendication 2 ou 3, caractérisé par le fait qu'il est prévu une résistance de précision placée à une tension constante, pour la production de commande (Ibiasp, Ibiasn) pour le circuit formant miroir de courant.

5. Montage suivant l'une des revendications précédentes, caractérisé par le fait que les transistors MOS commandables (M1,M4) peuvent être bloqués simultanément.

6. Montage suivant l'une des revendications précédentes, caractérisé par le fait que des condensateurs de blocage (C_{B1}, C_{B4}) sont raccordés aux bornes de grille des transistors MOS commandables (M1,M4).
